Europäisches Patentamt

(19) European Patent Office

Office européen des brevets

(11) Publication number: **0 042 494**
**A1**

(12) **EUROPEAN PATENT APPLICATION**

(21) Application number: **81103871.0**

(22) Date of filing: **20.05.81**

(51) Int. Cl.³: **C 30 B 11/00**
**C 30 B 29/48, C 01 B 19/00**

(30) Priority: **22.05.80 US 152283**

(43) Date of publication of application:
**30.12.81 Bulletin 81/52**

(84) Designated Contracting States:
**DE FR GB**

(71) Applicant: **HONEYWELL INC.**
**Honeywell Plaza**
**Minneapolis, Minnesota(US)**

(72) Inventor: **Lancaster, Robert A.**
**51 Philbrick Road**
**Brookline, Massachusetts 02146(US)**

(74) Representative: **Rentzsch, Heinz et al,**
**Honeywell Europe S.A. Holding KG Kaiserleistrasse 55**
**D-6050 Offenbach am Main(DE)**

(54) **Method and apparatus for forming ingots of a semiconductor alloy.**

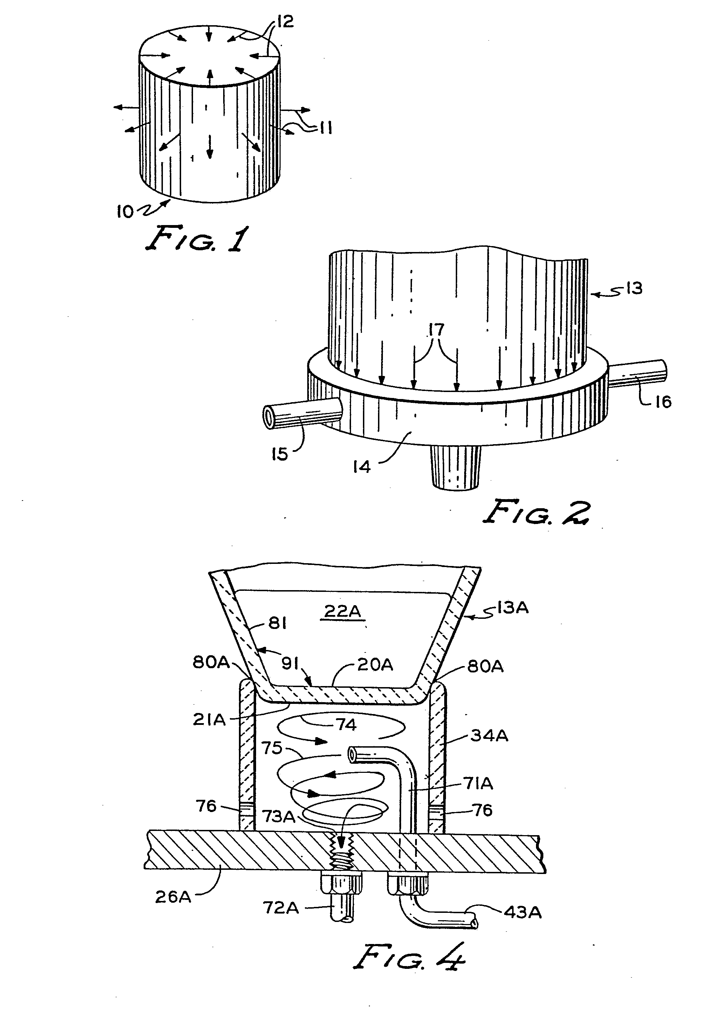

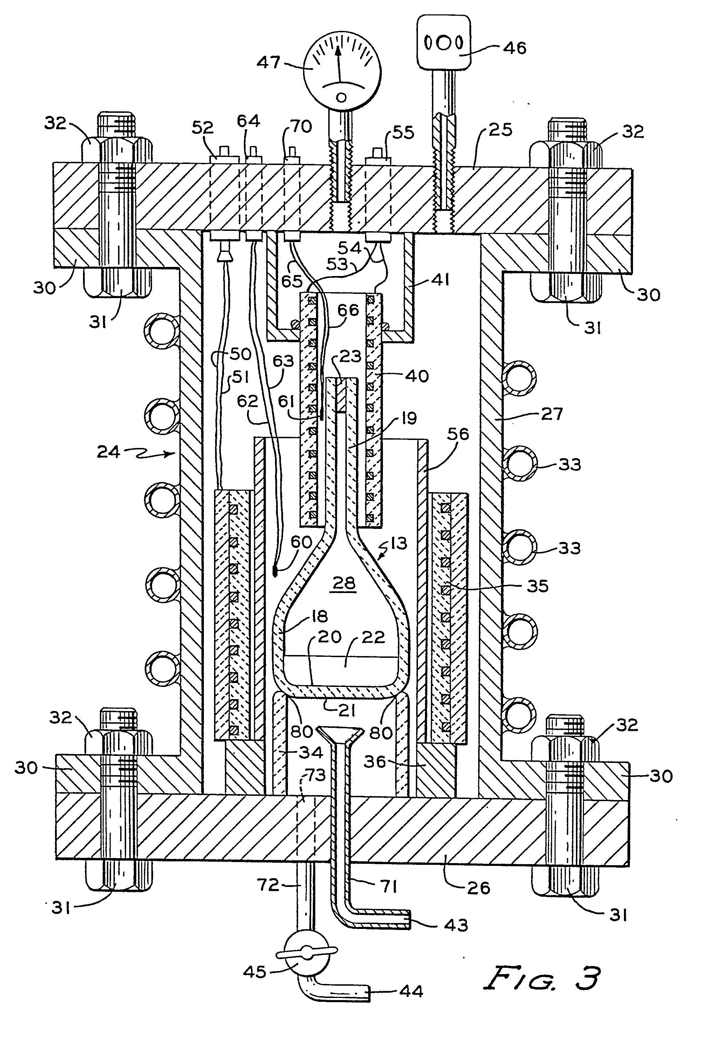

(57) In connection with a method and an apparatus for controlled directional solidification of semiconductor alloys of at least two constituents the method comprises heating at least two different constituents so that they are combined in a liquid phase molten material of uniform composition with at least a portion of the molten material lying in a plane, and rapidly cooling at least a portion of the molten material so that a planar solidification front passes rapidly through at least a portion of the molten material in a direction perpendicular to the plane until at least a portion of the molten material is rapidly solidified. The apparatus comprises a vessel (13) for containing the constituents (22) of the alloy, the vessel having an interior planar surface (20). Also included is heating apparatus (35,40) for heating the constituents in the vessel so that a liquid phase molten material of uniform composition is formed. The apparatus further comprises cooling apparatus (71-73) for rapidly supplying uniform cooling to the interior planar surface in order to cause rapid solidification in at least a portion of the molten material, whereby a planar solidification front passes rapidly through at least a portion of the molten material in a direction perpendicular to the interior planar surface of the vessel (Figure 3).

EP 0 042 494 A1

0042494

HONEYWELL INC.

Honeywell Plaza

Minneapolis, Minnesota, USA

19. Mai 1981

1008699 EP

Hz/de

METHOD AND APPARATUS FOR FORMING

INGOTS OF A SEMICONDUCTOR ALLOY.

## BACKGROUND OF THE INVENTION

The present invention relates to controlled directional solidification of semiconductor alloys and the formation of large-area ingots of such alloys. Although disclosed as being related to mercury cadmium telluride ($Hg_{1-x}Cd_xTe$), the present invention is also applicable to semiconductor alloys in general, particularly to such alloys that have at least two constituents, one of which is volatile. With regard to $Hg_{1-x}Cd_xTe$, there is interest in growth of large area ingots for applications such as monolithic arrays and staring sensors.

All prior art techniques known to the applicant suffer from a fundamental problem, the inability to remove heat from the ingot in a rapid, uniform manner in order to yield material with constant x values.

Non-equilibrium (e.g., quench anneal) techniques are especially vulnerable to this problem. Equilibrium techniques (e.g., zone leveling, Bridgman), while less affected by this heat removal problem, are plagued with heat input problems, making it very difficult, if at all possible, to achieve a flat freezing interface. There is also a significant problem of designing a suitable ampoule of sufficient strength for large diameters, e.g., over 2,5 cm

In typical prior art processes, heat is normally lost from a filled crucible by radiation to cold furnace walls and conduction through high pressure gas ambient. Both of these processes require a rather slow conduction of heat from the center of the ingot to the outside where it is removed. For small volumes, this is not a significant problem. For large volumes (probably anything over about 2,5 cm), it becomes very significant.

## SUMMARY OF THE INVENTION

The present invention comprises a method and an apparatus for controlled directional solidification of semiconductor alloys of at least two constituents.

The method comprises heating at least two different constituents so that they are combined in a liquid phase molten material of uniform composition with at least a portion of the molten material lying in a plane, and rapidly cooling at least a portion of the molten material so that a planar solidification front passes rapidly through at least a portion of the molten material in a direction perpendicular to the plane until at least a portion of the molten material is rapidly solidified.

The apparatus comprises a vessel for containing the constituents of the alloy, the vessel having an interior planar surface. Also included is heating apparatus for heating the constituents in the vessel so that a liquid phase molten material of uniform composition is formed. The apparatus further comprises cooling apparatus for rapidly supplying uniform cooling to the interior planar surface in order to cause rapid solidification in at least a portion of the molten material, whereby a planar solidification front passes rapidly through at least a portion of the molten material in a direction perpendicular to the interior planar surface of the vessel.

## BRIEF DESCRIPTION OF THE DRAWINGS

Figure 1 illustrates cooling problems typical of prior art processes.

Figure 2 schematically illustrates apparatus compatible with the present invention.

Figure 3 is a more complete illustration of apparatus compatible with the present invention.

Figure 4 illustrates alternate embodiments of apparatus compatible with the present invention.

## DESCRIPTION OF THE PREFERRED EMBODIMENTS

Cooling problems typical of prior art processes are illustrated in Figure 1 which depicts a portion of an ingot 10 grown by a typical prior art quench growth method. Heat flow is illustrated by arrows 11 pointing radially outward, the direction of cooling and solidification being illustrated by arrows 12 pointing radially inward. Such cooling results in radial inhomogenities in the ingot.

In contrast, the present invention will yield ingots of at least several inches in diameter while providing the uniform rapid cooling needed to yield uniform composition.

Apparatus compatible with the present invention is schematically illustrated in Figure 2. Shown is a lower portion of a large-diameter vessel or ampoule 13 in which a large but shallow charge of mercury, cadmium, and tellurium is melted into a stoichiometric liquid mixture. With ampoule 13 resting on a coolable pedestal or plate 14, ampoule 13 is cooled by rapidly and uniformly chilling pedestal 14, as by flowing a cooling medium such as an inert gas (e.g., nitrogen) through the pedestal via an inlet 15 and an outlet 16. Heat is then uniformly drawn out of the melt, as depicted by arrows 17, resulting in a disc of $Hg_{1-x}Cd_xTe$. Using the present invention, it is anticipated that ingots with uniform composition and diameters of 15 cm or more may be possible.

A more complete illustration of apparatus compatible with the present method is contained in Figure 3. Shown is an ampoule 13 having a large-diameter inside flat bottom 20 establishing an inside planar surface, the bottom enclosure member of ampoule 13 typically comprising an area of uniform cross-sectional thickness and, therefore, a flat outer bottom surface 21. Ampoule 13 may be formed of quartz (preferably fused quartz) and may comprise a quartz tube 18 and a quartz capillary tube 19. The ampoule is shown supported by a quartz spacing ring 34, an interface 80 between support ring 34 and ampoule 13 helping to prevent undesirable gas flow to the sidewalls of ampoule 13 as further discussed below. Constituents 22, which may comprise mercury, cadmium, and tellurium and which will form the melt and ingot, are shown in ampoule 13. Vessel 13 is typically of sufficient size to comprise an open volume 28 above the constituents.

In the embodiment shown, melt stoichiometry is maintained by sealing ampoule 13 with a plug 23 and by maintaining an appropriate mercury vapor pressure over the constituents. Stoichiometry may also be maintained through refluxing using an unsealed ampoule as is typical in the "ADL" (Arthur D. Little) technique.

Ampoule 13 is shown housed by a pressure chamber 24 comprising an upper end plate 25, a lower end plate 26, and a flanged pipe 27, end plates 25 and 26 being bolted to pipe 27 via flanges 30, bolts 31, and nuts 32. A primary purpose of pressure chamber 24 is to minimize the chances of ampoule 13 being ruptured or distorted by the mercury vapor pressures which are formed within the ampoule upon heating of the constituents. The chamber shown is

-5-

pressurized and the chamber pressure regulated via an inlet 43, an outlet 44, and a metering valve 45, a pressure gauge 47 being used to monitor the chamber pressure. An inert gas such as nitrogen may be used to pressurize the chamber, the chamber pressure typically being regulated to be in substantial equilibrium with the pressure in ampoule 13. A blow off safety valve 46 may also be included. Chamber 24 may be cooled by water coils 33 in order to prevent the chamber from becoming excessively hot. Pipe 27 may comprise stainless steel tubing. End plates 25 and 26 may also be formed of stainless steel.

A lower heater 35 typically surrounds a lower portion of ampoule 13, heater 35 serving to melt constituents 22. An upper or side arm heater 40, which may surround an upper portion of ampoule 13, is typically used to heat the vapor in open volume 28 to a temperature appropriate for maintaining an appropriate vapor pressure above the constituents so that a stoichiometric mixture is maintained. Heaters 35 and 40 are shown supported by a firebrick pedestal 36 and a hanger bracket 41 respectively. Power to heaters 35 and 40 may be supplied through cables and power feedthroughs, heater 35 being connected to a feedthrough 52 via cables 50 and 51, heater 40 being connected to a feedthrough 55 via cables 53 and 54.

An isothermal liner 56 is typically included between heater 35 and ampoule 13 in order to provide uniform heat distribution, isothermal liner 56 being a heat pipe.

The temperatures provided by heaters 35 and 40 are shown monitored by thermocouples 60 and 61 respectively, thermocouple 60 being located between isothermal liner 56 and a lower portion of ampoule 13, thermocouple 61 being located between heater 40 and an upper portion of ampoule 13. Thermocouples 60 and 61 may be monitored via cables and thermocouple feedthroughs, thermocouple 60 being connected to a feedthrough 64 via cables 62 and 63, thermocouple 61 being connected to a feedthrough 70 via cables 65 and 66.

In the embodiment shown in Figure 3, pressure inlet port 43 is illustrated as comprising a tube 71 passing through the center of lower end plate 26, the upper end of tube 71 terminating below the center of ampoule 14 in an open volume within support ring 34. The upper end of tube 71 is shown flared open to more uniformly distribute gases over the ampoule outer bottom surface 21 during the cooling process.

Outlet port 44 is illustrated as comprising a tube 72, the tube being connected through a metering valve 45 to a port 73 in lower end plate 26, port 73 connecting to the open volume below ampoule outer surface 21. In using the apparatus shown in Figure 3 to rapidly and uniformly cool ampoule bottom 21 and, therefore, to rapidly and uniformly cool ampoule inside flat bottom 20, metering valve 45 is opened to allow gas to rapidly and uniformly flow onto surface 21.

An alternate embodiment of apparatus compatible with the present invention is illustrated in Figure 4. Shown is a lower end plate 26A, a supporting ring 34A resting on the end plate, a lower portion of an ampoule 13A supported by ring 34A, and constituents 22A within ampoule 13A. An inlet port 43A comprises a tube 71A passing through lower end plate 26A to an open volume below ampoule 13A. The upper portion of tube 71A is configured so that, during the cooling process, gases will be rapidly and uniformly distributed in a motion comprising a spiral onto ampoule bottom surface 21A. Such cooling is schematically illustrated by arrows 74 and 75, arrow 75 also illustrating the escape of gases through port 73A and outlet tube 72A which passes through lower end plate 26A. Pressure relief holes 76 are shown in supporting ring 34A, holes 76 preventing excessive pressure buildup below the ampoule. Interface 80A between support ring 34A and ampoule 13A helps to prevent undesirable gas flow to the sidewalls of ampoule 13A, it being of interest to prevent extraneous cooling from the sidewalls.

The lower portion of ampoule 13A comprises sidewall inner surface 81 which forms an angle 91 with flat bottom 20A such that angle 91 is greater than 90 degrees. The purpose of the angled sidewall is to facilitate removal of ingot 22A from ampoule 13A.

In applying the present invention, the constituents to comprise the alloy are placed in an appropriately cleaned ampoule and heated above the liquidus temperature so that they are combined into a liquid phase molten material of uniform composition, open volume 28 being evacuated prior to sealing the ampoule, if a closed ampoule is used. Stoichiometry is maintained through an appropriate vapor pressure being maintained above the constituents as previously indicated. The inside flat bottom 20 or 20A of the ampoule is then rapidly and uniformly cooled so that a planar solidification front rapidly passes through at least a portion of the molten material in a direction perpendicular to the plane established by the inside flat bottom until at least a portion of the molten material is rapidly solidified.

Obviously, the cooling may be provided by means such as flowing a cooling medium thermally coupled to a planar surface, by flowing a cooling medium through a cooling structure such as a pedestal or plate thermally coupled to a planar surface, or by other means.

## CLAIMS

1. A method for forming an ingot of a semiconductor alloy of at least two different constituents, c h a r a c - t e r i z e d   b y  the following steps:
heating the constituents so that they are combined in a liquid phase molten material of uniform composition with at least a portion of the molten material lying in a plane; and
rapidly cooling at least a portion of the molten material so that a planar solidification front passes rapidly through at least a portion of the molten material in a direction perpendicular to the plane until at least a portion of the molten material is rapidly solidified.

2. The method according to claim 1,   c h a r a c t e r - i z e d   i n   t h a t  a cooling medium is rapidly and uniformly thermally coupled to the plane.

3. The method according to claim 1 or 2,   c h a r a c - t e r i z e d   i n   t h a t   the colling medium is an inert gas.

4. The method according to one of claims 1 to 3,  c h a r - a c t e r i z e d   i n   t h a t  an appropriate vapor pressure is maintained over the constituents in order to prevent decomposition and to maintain stoichiometry of the material.

5. The method according to one of claims 1 to 4,  c h a r - a c t e r i z e d   i n   t h a t  the plane is positioned horizontally for the cooling step.

6. The method according to one of claims 1 to 5,  c h a r - a c t e r i z e d   i n   t h a t  the constituents comprise mercury, cadmium, and tellurium in order to form an ingot of  $Hg_{1-x}Cd_xTe$.

7. An apparatus for performing the method according to one of the foregoing claims, c h a r a c t e r i z e d b y :

a vessel (13,13A) for containing the constituents (22) of the alloy, the vessel having an interior planar surface (20,20A);

heating means (35,40) for heating the constituents in the vessel so that a liquid phase molten material of uniform composition is formed; and

cooling means (14-16;71,72) for rapidly supplying uniform cooling to the interior planar surface in order to cause rapid solidification in at least a portion of the molten material, whereby a planar solidification front passes rapidly through at least a portion of the molten material in a direction perpendicular to the interior planar surface of the vessel.

8. The apparatus according to claim 7, c h a r a c t e r - i z e d   i n   t h a t   the interior planar surface (20,20A) is part of an enclosure member (18), that at least a part of the enclosure member having uniform thickness, thereby providing an exterior planar surface (21), and that at least a part of the enclosure member having substantially uniform heat transfer capability throughout.

9. The apparatus according to claim 7 or 8, c h a r a c - t e r i z e d   i n   t h a t   the cooling means comprises means (71-73, 43-45) for rapidly and uniformly thermally coupling a cooling medium with the interior planar surface (20).

10. The apparatus according to one of claims 7 to 9, c h a r a c t e r i z e d   i n   t h a t   the cooling medium is an inert gas.

11. The apparatus according to one of claims 7 to 10, c h a r a c t e r i z e d i n t h a t the cooling means comprises a colling plate (80) thermally coupled to the interior planar surface.

12. The apparatus according to one of claims 7 to 11, c h a r a c t e r i z e d i n t h a t it comprises a pressure chamber (24) for applying a pressure to at least a portion of the vessel (13) exterior.

13. The apparatus according to one of claims 7 to 12, c h a r a c t e r i z e d i n t h a t the vessel (13) is sufficiently large to contain an open volume (28) above the constituents (22), the open volume being evacuated and the vessel and open volume sealed prior to heating the constituents, the pressure in the pressure chamber (24) being regulated to be in substantial equilibrium with vapor pressure that forms in the open volume upon heating of the constituents, the sealed vessel preventing the escape of constituent vapor, the pressure in the chamber minimizing the chance of interior planar surface distortion and vessel rupture.

14. The apparatus according to one of claims 7 to 13, c h a r a c t e r i z e d i n t h a t the heating means comprises means (35,40) for heating the vapor in the open volume (28) to a temperature appropriate for obtaining an appropriate vapor pressure over the constituents (22) so that a stoichiometric mixture is maintained.

15. The apparatus according to one of claims 7 to 14, c h a r a c t e r i z e d i n t h a t the heating means (35,40) is arranged within the pressure chamber (24).

16. The apparatus according to one of claims 7 to 15, c h a r a c t e r i z e d i n t h a t the heating means (35,40) comprises isothermal structure means for providing a uniform temperature to at least a portion of the vessel (13).

17. The apparatus according to one of claims 7 to 16, c h a r a c t e r i z e d i n t h a t the vessel (13A) comprises a sidewall (81) which forms an angle greater than 90 degrees with the interior planar surface (20A).

18. The apparatus according to one of claims 7 to 17, c h a r a c t e r i z e d i n t h a t the vessel (13) is fabricated of quartz.

FIG. 1

FIG. 2

FIG. 4

FIG. 3

0042494

European Patent Office

EUROPEAN SEARCH REPORT

Application number

EP 81 10 3871

| | DOCUMENTS CONSIDERED TO BE RELEVANT | | CLASSIFICATION OF THE APPLICATION (Int Cl.3) |
|---|---|---|---|
| Category | Citation of document with indication, where appropriate, of relevant passages | Relevant to claim | |
| | JAPANESE JOURNAL OF APPLIED PHYSICS vol. 11, no. 2, February 1972, K. SHINOHARA et al. "The crystal growth of homogeneous $Hg_{1-x}Cd_xTe$ by the Bridgman method" pages 273-274.<br><br>* Page 283, figure 2 *<br><br>-- | 1,5,6 | C 30 B 11/00 29/48 C 01 B 19/00 |
| | US - A - 3 468 363 (S. PARKER)<br>* Claims 1,3; figure 1 *<br><br>-- | 1-5, 7-10, 13,14, 18 | |
| | FR - A - 2 175 594 (R.T.C.)<br>* Page 7, lines 6-17 *<br><br>-- | 1,2,5 | TECHNICAL FIELDS SEARCHED (Int. Cl.3)<br><br>C 30 B 11/00 29/48 C 01 B 19/00 |
| | FR - A - 2 078 647 (TEXAS INSTRUMENTS)<br>* Claims 1,9,11; figures 1,3 *<br><br>-- | 1,3,4, 6,14 | |
| | JOURNAL OF CRYSTAL GROWTH, vol. 46, 1979, B.E. BARTLETT et al. "The effects of growth speed on the compositional variations in crystals of cadmium mercury telluride", pages 623-629.<br><br>* Page 624 *<br><br>---- | 1,6 | CATEGORY OF CITED DOCUMENTS<br><br>X: particularly relevant<br>A: technological background<br>O: non-written disclosure<br>P: intermediate document<br>T: theory or principle underlying the invention<br>E: conflicting application<br>D: document cited in the application<br>L: citation for other reasons<br><br>&: member of the same patent family.<br>corresponding document |

The present search report has been drawn up for all claims

| Place of search | Date of completion of the search | Examiner |
|---|---|---|
| The Hague | 07-10-1981 | BRACKE |

EPO Form 1503 1 06.78